# FASCICULE DE BREVET EUROPEEN

(11) **EP 2 205 053 B1**
(45) Date de publication et mention de la délivrance du brevet: **20.11.2013**
(21) Numéro de dépôt: 10150191.4
(22) Date de dépôt: 06.01.2010
(51) Int. Cl.: H05K 3/38, H05K 3/46

(54) **Procédé de réalisation d'une carte imprimée et carte imprimée correspondante**
Gedruckte Schaltkreiskarte und Verfahren für dessen Herstellung
Printed circuit card and process for producing such a card

(30) Priorité: 06.01.2009 FR 0900024
(43) Date de publication de la demande: 07.07.2010
(73) Titulaire: Thales, 92200 Neuilly Sur Seine (FR)
(72) Inventeur: Ledain, Bernard, 92310 Sèvres (FR); Henriot, Dominique, 92140 Clamart (FR)
(74) Mandataire: Lucas, Laurent Jacques

(56) Documents cités:
- EP-A- 1 075 172
- WO-A-02/49404
- WO-A-96/08945
- WO-A-2004/088731
- US-A1- 2004 229 024

## Description

L'invention porte sur les cartes imprimées, et plus particulièrement sur la façon de connecter entre elles les différentes couches métallisées formant une carte imprimée.

En d'autres termes, chaque couche métallisée forme un circuit imprimé, c'est-à-dire une portion de la carte imprimée.

Classiquement des trous métallisés traversant les couches métalliques sont réalisés, de manière à assurer les liaisons électriques entre les différentes couches du circuit.

De préférence, les trous sont percés uniquement entre les couches à relier. Par exemple, pour une carte imprimée de quatre couches, si seules les troisième et quatrième couches doivent être reliées, des trous sont réalisés uniquement entre ces deux couches avant de les assembler, afin de former un circuit multicouches.

Différentes contraintes se posent alors pour la réalisation des trous, à savoir :
- une adaptation du diamètre des trous, à l'épaisseur des couches à traverser, de façon à réaliser de manière fiable les trous traversants ;
- une limitation des effets d'antenne, pouvant être gênant dans le cas où le circuit comporte des fonctions hyperfréquences.

Différentes solutions existent pour répondre en partie à ces différentes contraintes :
- un perçage des trous à l'aide d'un laser,
- la réalisation des cartes imprimées de façon séquentielle, et
- un contre-perçage des trous métallisés pour retirer le métal inutile.

Une solution partielle a été apportée par la demande de brevet d'invention FR 2 818 870.

Ce document décrit la réalisation d'une carte imprimée multicouches par un empilage de couches métallisées sur chacune de leurs faces, percées de trous métallisés et soudées à l'aide d'une diffusion du métal entre les trous métallisés.

Une couche intercalaire pré-imprégnée d'une substance adhésive, est alors utilisée pour coller les différents couches métallisées entre-elles.

Chaque couche intercalaire doit également être percée avec un diamètre supérieur pour tenir compte du fluage de la substance adhésive en regard des trous métallisés à connecter.

Avec la densification des connexions à réaliser, chaque couche intercalaire de retrouve percée de multiples trous, pouvant être tangents. Cela rend très difficile sa manipulation et limite la densité possible des connexions.

Un document WO 96/08945 A qui refléte le préambule de la revendication 1, décrit un module de câblage microélectronique à polymères à cristaux liquides. Un document EP 1 075 172 A décrit un circuit imprimé multicouches comportant une structure de trous d'interconnexions pleins. Un document WO 2004/088731 A décrit un procédé de réalisation d'une carte imprimée.

L'invention vise notamment à résoudre les problèmes précités.

A cet effet, selon un premier aspect de l'invention, il est proposé un procédé de réalisation d'une carte imprimée comprenant au moins deux couches superposées, métallisées sur leurs deux faces, et au moins une couche intercalaire disposée entre deux couches métallisées successives.

Selon une caractéristique générale de ce premier aspect, on réalise chaque couche intercalaire à l'aide d'un matériau thermoplastique métallisé.

L'invention a pour avantage de proposer une couche intercalaire dans un matériau insensible aux éléments chimiques contrairement aux couches pré-imprégnées utilisées dans les solutions existantes, qui sont collantes avant leur polymérisation.

Avec une couche intercalaire selon l'invention, il n'existe aucun risque de fluage du matériau thermoplastique métallisé lors de la formation du circuit imprimé.

En conséquence, il est possible d'augmenter la densité de trous percés au sein des différentes couches.

Selon un mode de mise en oeuvre, le procédé comporte :
- une étape de perçage de trous en correspondance au sein des couches métallisées devant être mises en contact et des couches intercalaires disposées entre les couches métallisées considérées,
- une métallisation des trous réalisés au sein des couches métallisées et des couches intercalaires,
- une application d'un premier métal sur chaque ouverture des trous des couches métallisées considérées,
- une application d'un deuxième métal sur chaque ouverture des trous des couches intercalaires considérées, et
- un pressage des couches métallisées et desdites couches intercalaires superposées, de façon à souder par diffusion les zones recouvertes d'un premier métal avec les zones recouvertes d'un deuxième métal qui sont en contact.

De préférence, préalablement à l'application du deuxième métal, chaque surface de chaque couche intercalaire peut être gravée de façon à ne garder qu'une pastille de métal autour des ouvertures des trous percés.

Par exemple, le matériau thermoplastique peut être un polymère à cristaux liquides.

Selon un mode de mise en oeuvre, le pressage des couches métallisées et desdites couches intercalaires superposées peut être réalisé à la température de fusion du matériau thermoplastique dans lequel sont réalisées les couches intercalaires.

Selon un autre aspect de l'invention, il est proposé une carte imprimée comprenant au moins deux couches métallisées superposées, et au moins une couche intercalaire disposée entre deux couches métallisées successives.

Selon une caractéristique générale de cet autre aspect, chaque couche intercalaire est en un matériau thermoplastique métallisé.

Selon un mode de réalisation, le circuit imprimé peut comprendre au moins une couche métallisée et une couche intercalaire en contact, respectivement percées de trous métallisés en regard, et les trous de chaque couche intercalaire peuvent être soudés aux trous métallisés correspondant de ladite couche métallisée adjacente, à l'aide de deux types de métaux différents.

D'autres avantages et caractéristiques de l'invention apparaîtront à l'examen de la description détaillée et d'un mode de mise en oeuvre et d'un mode de réalisation de l'invention, nullement limitatifs, et des dessins annexés sur lesquels :
- la figure 1 illustre un mode de mise en oeuvre d'un procédé de réalisation d'une carte imprimée selon l'invention, et
- la figure 2 représente un mode de réalisation d'une carte imprimée selon l'invention.

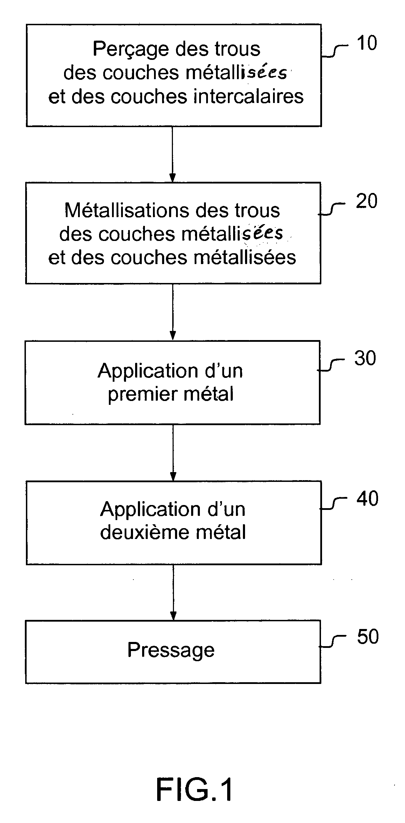

On se réfère tout d'abord à la figure 1. Cette figure illustre dans les grandes lignes un mode de mise en oeuvre d'un procédé de réalisation de cartes imprimées selon l'invention.

Chaque carte imprimée est formée de plusieurs couches métallisées (au moins deux) sur lesquelles est imprimée différentes portions d'un circuit.

Une première étape 10 comprend un perçage de trous permettant de relier entre elles des portions de circuits se trouvant sur différentes couches métallisées.

Cette étape 10 comprend également le perçage des couches intercalaires qui seront insérées entre deux couches métallisées.

Ces couches intercalaires sont réalisées en un matériau thermoplastique métallisé. Ce matériau thermoplastique peut être par exemple un polymère à cristaux liquides.

Le perçage des couches intercalaires est réalisé en fonction du perçage des couches métallisées qui l'encadrent, de façon qu'un trou percé dans la couche métallisée située au-dessus d'une couche intercalaire donnée puisse être connecté au trou correspondant percé dans la couche métallisée situés au-dessous de cette même couche intercalaire.

On procède ensuite à une métallisation des trous percés au sein des couches métallisées et de la couche intercalaire, 20.

Autrement dit, on dépose une couche de métal au sein des trous réalisés au sein de chaque couche.

On procède ensuite à une application d'un premier métal sur les ouvertures des trous de chaque couche métallisée 30. Ce premier métal peut être par exemple de l'étain.

De même on procède à une application d'un deuxième métal sur les ouvertures des trous de chaque couche intercalaire 40. Ce deuxième métal peut être par exemple de l'or ou de l'argent.

Préalablement à l'application du deuxième métal, il est possible de graver les surfaces supérieure et inférieure de chaque couche intercalaire, de manière à ne laisser qu'une pastille de métal autour des ouvertures des trous percés. Ce sont ces pastilles qui sont alors recouvertes dudit deuxième métal.

Les différentes couches sont alors pressées ensemble, 50. Ce pressage est réalisé à la température de fusion du matériau thermoplastique utilisée pour la réalisation des couches intercalaires.

Les couches intercalaires permettent de coller l'ensemble des couches entre elles. Par ailleurs, les ouvertures des trous recouvertes de métal, permettent de souder les trous des couches métallisées avec les trous de la couche intercalaire adjacente grâce au processus de diffusion.

Ce processus s'amorce lors du pressage, et s'effectue simultanément au collage des couches entre-elles.

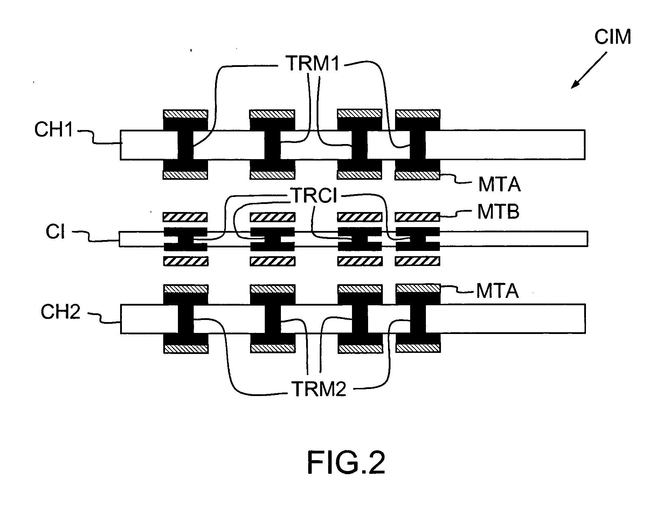

A présent, on se réfère à la figure 2 illustrant une coupe des différentes couches d'une carte imprimée CIM.

A des fins de simplification, les différentes couches du circuit sont représentées non collées, de façon à bien distinguer chacune des zones de la carte imprimée CIM.

On considère dans cet exemple que la carte imprimée CIM est formée de deux couches métallisées CH1 et CH2. Bien entendu, cet exemple n'est pas limitatif.

Une couche intercalaire CI est disposée entre les deux couches métallisées. Comme indiqué ci-avant, la couche intercalaire CI est réalisée dans un matériau thermoplastique métallisé.

La première couche métallisée CH1 située au-dessus de la pile, est percée de quatre trous TRM1 métallisés. Chaque ouverture des trous TRM1 est recouverte d'un premier métal MTA.

De même, la couche métallisée CH2 située au-dessous de la pile est percée de quatre trous TRM2 métallisés. Ces trous TRM2 sont réalisés en regard des trous TRM1 réalisés dans la première couche CH1, de façon à ce qu'ils puissent être connectés.

Chaque ouverture des trous TRM2 est également recouverte du premier métal MTA.

La couche intercalaire CI est également percée de trous TRCI correspondant aux trous TRM1 et TRM2 des première et deuxième couches métallisées CH1 et CH2.

Les trous métallisés TRM1 et TRM2 sont ici des trous traversants, mais ils pourraient également être borgnes.

Les trous TRCI de la couche intercalaire CI sont également métallisés. Par ailleurs, un deuxième type de métal MTB est déposé sur les ouvertures de trous TRCI de la couche intercalaire.

Les différents métaux déposés sur les ouvertures des trous des couches métallisées CH1, CH2 et de la couche intercalaire CI, permettent leur connexion grâce à la diffusion intermétallique qui s'opère lors du pressage des différentes couches entre elles.

## Revendications

1. Procédé de réalisation d'une carte imprimée comprenant au moins deux couches superposées, métallisées sur leurs deux faces, et au moins une couche intercalaire disposée entre deux couches métallisées successives, chaque couche intercalaire étant réalisée à l'aide d'un matériau thermoplastique métallisé, le procédé étant **caractérisé par le fait qu'**il comporte :
- une étape de perçage (10) de trous en correspondance au sein des couches métallisées devant être mises en contact et des couches intercalaires disposées entre les couches métallisées considérées,
- une métallisation (20) des trous réalisés au sein des couches métallisées et des couches intercalaires,
- une application d'un premier métal (30) sur chaque ouverture des trous des couches métallisées considérées,
- une application d'un deuxième métal (40) sur chaque ouverture des trous des couches intercalaires considérées, et
- un pressage (50) des couches métallisées et desdites couches intercalaires superposées, de façon à souder par diffusion les zones recouvertes d'un premier métal avec les zones recouvertes d'un deuxième métal qui sont en contact.

2. Procédé selon la revendication précédente, dans lequel préalablement à l'application du deuxième métal, chaque surface de chaque couche intercalaire est gravée de façon à ne garder qu'une pastille de métal autour des ouvertures des trous percés.

3. Procédé selon l'une des revendications précédentes, dans lequel le matériau thermoplastique est un polymère à cristaux liquides.

4. Procédé selon l'une des revendications précédentes, dans lequel le pressage des couches métallisées et desdites couches intercalaires superposées est réalisé à la température de fusion du matériau thermoplastique dans lequel sont réalisées les couches intercalaires.

5. Carte imprimée (CIM) comprenant au moins deux couches métallisées (CH1, CH2) superposées, et au moins une couche intercalaire (CI) disposée entre deux couches métallisées successives, chaque couche intercalaire étant en un matériau thermoplastique métallisé, **caractérisée en ce qu'**elle est réalisée conformément au procédé selon l'une quelconque des revendications précédentes.

6. Carte imprimée (CIM) selon la revendication précédente, comprenant au moins deux couches métallisées (CH1, CH2) et une couche intercalaire (CI) en contact, respectivement percées de trous métallisés en regard (TRM1, TRM2, TRCI), et dans lequel les trous (TRCI) de chaque couche intercalaire (CI) sont soudés aux trous métallisés (TRM1, TRM2) correspondant de ladite couche métallisée adjacente (CH1, CH2), à l'aide de deux types de métaux différents (MTA, MTB).

## Patentansprüche

1. Herstellungsverfahren einer Schaltkreiskarte, die mindestens zwei übereinanderliegende Schichten umfasst, die auf ihren zwei Seiten metallisiert sind, und mindestens eine Zwischenschicht, die zwischen zwei aufeinanderfolgenden metallisierten Schichten angeordnet ist, wobei jede Zwischenschicht mit Hilfe eines metallisierten thermoplastischen Materials hergestellt ist, wobei das Verfahren **dadurch gekennzeichnet ist, dass** es aufweist:
- einen Bohrungsschritt (10) von abgestimmten Löchern in den metallisierten Schichten, die in Kontakt gebracht werden müssen, und den Zwischenschichten, die zwischen den betroffenen metallisierten Schichten angeordnet sind,
- eine Metallisierung (20) der Löcher, die in den metallisierten Schichten und den Zwischenschichten hergestellt sind,
- ein Auftragen eines ersten Metalls (30) auf jede Öffnung der Löcher der betroffenen metallisierten Schichten,
- ein Auftragen eines zweiten Metalls (40) auf jede Öffnung der Löcher der betroffenen Zwischenschichten, und
- ein Pressen (50) der übereinanderliegenden metallisierten Schichten und der Zwischenschichten, so dass die mit einem ersten Metall bedeckten Zonen mit den Zonen, die mit einem zweiten Metall bedeckt sind, die im Kontakt sind, durch Diffusion verschweißt werden.

2. Verfahren nach dem vorangehenden Anspruch, wobei vor dem Auftragen des zweiten Metalls jede Fläche jeder Zwischenschicht derart graviert wird, dass nur ein Metallplättchen um die Öffnungen der gebohrten Löcher verbleibt.

3. Verfahren nach einem der vorangehenden Ansprüche, wobei das thermoplastische Material ein Flüssigkristallpolymer ist.

4. Verfahren nach einem der vorangehenden Ansprüche, wobei das Pressen der übereinanderliegenden Metallschichten und der Zwischenschichten bei der Schmelztemperatur des thermoplastischen Materials durchgeführt wird, aus dem die Zwischenschichten hergestellt sind.

5. Schaltkreiskarte (CIM), die mindestens zwei übereinanderliegende metallisierte Schichten (CH1, CH2) und mindestens eine Zwischenschicht (CI) umfasst, die zwischen zwei aufeinanderfolgenden metallisierten Schichten angeordnet ist, wobei jede Zwischenschicht aus einem metallisierten thermoplastischen Material ist, **dadurch gekennzeichnet, dass** sie nach dem Verfahren nach einem der vorangehenden Ansprüche hergestellt ist.

6. Schaltkreiskarte (CIM) nach vorangehendem Anspruch, die mindestens zwei metallisierte Schichten (CH1, CH2) und eine Zwischenschicht (CI) im Kontakt, jeweils mit gegenüberliegenden metallisierten Löchern (TRM1, TRM2, TRCI) durchbohrt, umfasst, und wobei die Löcher (TRCI) jeder Zwischenschicht (CI) mit den entsprechenden metallisierten Löchern (TRM1, TRM2) der benachbarten metallisierten Schicht (CH1, CH2), mit Hilfe von zwei unterschiedlichen Metalltypen (MTA, MTB) verschweißt sind.

## Claims

1. A method for producing a printed board comprising at least two superposed layers, which are metallised on their two faces, and at least one intermediate layer disposed between two successive metallised layers, each intermediate layer being produced using a metallised thermoplastic material, said method being **characterised in that** it comprises:
- a step of perforating (10) corresponding holes in the metallised layers designed to be brought into contact and the intermediate layers disposed between the considered metallised layers;
- a metallisation (20) of the holes produced in the metallised layers and the intermediate layers;
- an application of a first metal (30) on each opening of the holes of the considered metallised layers;
- an application of a second metal (40) on each opening of the holes of the considered intermediate layers, and
- the pressing together (50) of the metallised layers and said superposed intermediate layers, so as to diffusion weld the zones covered by a first metal with the zones covered by a second metal, which zones are in contact.

2. The method according to the preceding claim, wherein, prior to the application of the second metal, each surface of each intermediate layer is etched so that only a patch of metal is maintained around the openings of the perforated holes.

3. The method according to any one of the preceding claims, wherein the thermoplastic material is a liquid crystal polymer.

4. The method according to any one of the preceding claims, wherein the pressing together of the metallised layers and said superposed intermediate layers is realised at the melting temperature of the thermoplastic material of which the intermediate layers are produced.

5. A printed board (CIM) comprising at least two superposed metallised layers (CH1, CH2), and at least one intermediate layer (CI) disposed between two successive metallised layers, with each intermediate layer being made from a metallised thermoplastic material, **characterised in that** it is produced in accordance with the method according to any one of the preceding claims.

6. The printed board (CIM) according to the preceding claim, comprising at least two metallised layers (CH1, CH2) and one intermediate layer (CI) in contact, respectively perforated with facing metallised holes (TRM1, TRM2, TRCI), and wherein the holes (TRCI) of each intermediate layer (CI) are welded to the corresponding metallised holes (TRM1, TRM2) of said adjacent metallised layer (CH1, CH2) using two different types of metals (MTA, MTB).
